# FASCICULE DE BREVET EUROPEEN

(11) **EP 2 150 897 B1**
(45) Date de publication et mention de la délivrance du brevet: **26.04.2017**
(21) Numéro de dépôt: 08805805.2
(22) Date de dépôt: 19.05.2008
(51) Int. Cl.: G06F 17/50, G06F 11/26, G06F 11/34, G06F 11/36

(54) **PROCEDE DE SIMULATION D'UN SYSTEME EMBARQUE A BORD D'UN AERONEF POUR TESTER UN LOGICIEL DE FONCTIONNEMENT ET DISPOSITIF POUR LA MISE EN OEUVRE DE CE PROCEDE**
VERFAHREN ZUR SIMULATION EINES SYSTEMS AN BORD EINES FLUGZEUGS ZUM TESTEN UND BETREIBEN EINES SOFTWARE-PROGRAMMS UND VORRICHTUNG ZUR ANWENDUNG DIESES VERFAHRENS
METHOD FOR SIMULATING A SYSTEM ON BOARD AN AIRCRAFT FOR TESTING AN OPERATING SOFTWARE PROGRAM AND DEVICE FOR IMPLEMENTING SAID METHOD

(30) Priorité: 24.05.2007 FR 0755235
(43) Date de publication de la demande: 10.02.2010
(73) Titulaire: AIRBUS OPERATIONS (S.A.S), 31060 Toulouse (FR)
(72) Inventeur: RANDIMBIVOLOLONA, Famantanantsoa, F-31300 Toulouse (FR)
(74) Mandataire: Gicquel, Olivier Yves Gérard
(86) Numéro de dépôt international: PCT/FR2008/050859
(87) Numéro de publication internationale: WO 2008/142355

(56) Documents cités:
- EP-A- 0 567 722
- US-A- 5 815 653
- US-A1- 2003 009 305

## Description

### Domaine de l'invention

La présente invention appartient au domaine de la sécurité de fonctionnement des systèmes lorsque le fonctionnement de ces systèmes dépend de l'exécution dans un calculateur de suites d'instructions logiques.

En particulier, l'invention a pour objet un procédé de simulation d'un système devant exécuter des suites d'instructions logiques, notamment d'un système ayant des exigences de sécurité élevées tel qu'un système électronique destiné à être embarqué à bord d'un aéronef.

Le procédé permet, à un utilisateur, de pouvoir exécuter les suites d'instructions logiques regroupées dans des logiciels de fonctionnement de systèmes embarqués sur une plateforme hôte, autre que les moyens matériels sur lesquels les logiciels sont destinés à être exécutés normalement. La présente invention trouve des applications particulièrement avantageuses, mais non exclusives, dans le domaine de l'aéronautique et, plus particulièrement, dans le domaine de la réalisation de tests de logiciels de fonctionnement de systèmes embarqués.

### Etat de la technique

Pour des raisons de sécurité, les systèmes destinés à être embarqués à bord d'un aéronef sont soumis à des vérifications de bon fonctionnement au cours desquels il doit être démontré que lesdits systèmes répondent à des exigences de certification, avant qu'un aéronef équipé de tels systèmes soit autorisé à voler et, plus encore, à entrer en service commercial.

Actuellement, avant leur implantation, ces systèmes subissent de nombreux tests pour vérifier qu'ils répondent aux exigences d'intégrité et de sécurité, entre autres, émises par les autorités de certification. Ces systèmes embarqués peuvent être, notamment, des calculateurs spécialisés destinés à réaliser des fonctions pouvant être importantes pour l'aéronef, par exemples des fonctions de pilotage. Ces systèmes seront appelés par la suite calculateurs.

Le plus souvent, dans les architectures des systèmes actuels, chaque calculateur est dédié à une application ou à plusieurs applications de même nature, par exemple des applications de commande de vol. Chaque calculateur comprend une partie matérielle et une partie logicielle. La partie matérielle comporte au moins une unité de traitement central (CPU: Central Processing Unit en anglais) et au moins une unité d'entrées/sorties par laquelle le calculateur est connecté à un réseau de calculateurs, à des périphériques externes, etc...

Une caractéristique essentielle des systèmes embarqués, souvent mis en oeuvre dans le domaine aéronautique, est liée à une architecture, tant matérielle que logicielle, qui évite l'introduction, autant que possible, de tout moyen non nécessaire pour exécuter les fonctions dédiées auxdits systèmes.

Ainsi, contrairement aux systèmes généralement rencontrés dans des applications répandues, en aéronautique, le calculateur n'est pas pourvu d'un système d'exploitation complexe. De plus, le logiciel est réalisé dans un langage aussi proche que possible du langage compris par l'unité de traitement central et les seules entrées/sorties disponibles sont celles nécessaires au fonctionnement du système, par exemple des informations provenant de capteurs ou d'autres éléments de l'aéronef ou des informations à destination d'actionneurs ou d'autres éléments.

L'avantage de ce type d'architecture tient au fait que le fonctionnement d'un tel système est beaucoup mieux maîtrisé. Il n'est pas dépendant d'un système d'exploitation complexe dont certains aspects du fonctionnement sont fonction de paramètres non maîtrisés et qui devrait, sinon, faire l'objet des mêmes démonstrations de sécurité que les logiciels d'application. Le système est plus simple et moins vulnérable car il ne comporte que les moyens strictement nécessaires à l'exécution des fonctions confiées audit système.

En contrepartie, le fonctionnement d'un tel système est beaucoup plus difficile à observer. Par exemple, le système ne dispose pas des interfaces homme/machine conventionnelles, comme les claviers et écrans, permettant de vérifier le déroulement correct des suites d'instructions et d'interagir sur ce déroulement, ce qui rend difficile les vérifications indispensables pendant le développement, la vérification et la qualification des logiciels.

La partie logicielle du calculateur comprend un logiciel spécifique à l'application considérée et qui assure le fonctionnement du calculateur, dont les instructions logiques correspondent aux algorithmes qui déterminent le fonctionnement du système.

Pour obtenir la certification du système, préalable à sa mise en service et à celle de l'aéronef, une phase de validation du calculateur est effectuée.

De façon connue, la phase de validation consiste, en général, à vérifier, à chaque étape du processus de réalisation du calculateur, que celui-ci est conforme aux spécifications qui ont été établies pour que ledit calculateur réponde au fonctionnement attendu du système.

Cette conformité aux spécifications est réalisée, en particulier pour les logiciels, par étapes successives depuis la vérification des composants les plus simples du logiciel jusqu'au logiciel complet intégrant tous les composants devant être intégrés dans le calculateur cible.

Dans une première étape de vérification, les éléments de logiciel les plus simples pouvant être testés sont soumis à des tests, dits tests unitaires. Au cours de ces tests, il est vérifié que les instructions logiques, c'est-à-dire le code, desdits éléments de logiciel ont été, pris individuellement, réalisés conformément aux exigences de conception.

Dans une deuxième étape, dite étape d'intégration, différents composants logiciels, ayant été soumis individuellement à une vérification isolée, sont intégrés pour constituer un ensemble dans lequel les composants logiciels interagissent. Ces différents composants logiciels sont soumis à des tests d'intégration destinés à vérifier que les composants logiciels sont compatibles, en particulier au niveau des interfaces fonctionnelles entre lesdits composants.

Dans une troisième étape, l'ensemble des composants logiciels est intégré dans le calculateur auquel ils sont destinés. Des essais de validation sont alors réalisés pour démontrer que le logiciel, formé par l'ensemble des composants intégrés dans le calculateur, est conforme à la spécification, c'est-à-dire qu'il réalise les fonctions attendues, et que son fonctionnement est fiable et sûr.

Pour garantir qu'un logiciel est sûr, et pour satisfaire aux exigences de certification, il est également nécessaire, au cours de cette phase de validation, de démontrer que l'ensemble des tests auxquels le logiciel a été soumis permet de conclure, avec un niveau d'assurance adéquat, que le logiciel est conforme aux exigences de sûreté requises du système où il est incorporé.

Les différents tests effectués, pendant la phase de validation, sur le logiciel, permettent de s'assurer qu'aucun dysfonctionnement dudit logiciel (qui pourrait avoir un impact sur le bon fonctionnement des calculateurs, et par suite sur l'aéronef et sa sécurité) ne peut se produire ou que, si un dysfonctionnement se produit, le logiciel est apte à le maîtriser.

Toutefois, pendant la phase de validation, et surtout pour les opérations d'investigation lorsque des anomalies sont constatées, il est souvent nécessaire de s'assurer que, non seulement, les paramètres d'entrée et de sortie du calculateur sur lequel est implanté le logiciel sont conformes aux attentes mais, également, que certains comportements internes du logiciel sont corrects.

Dans ce cas, en raison de l'architecture spécifique des calculateurs spécialisés pour les applications embarquées, il est généralement très difficile d'observer le fonctionnement du logiciel sans mettre en oeuvre des dispositifs et des méthodes particulières.

Une première méthode connue consiste à mettre en place un système de distribution de fichiers entre le calculateur en test avec le logiciel implanté et une plateforme associée, en utilisant des émulateurs. On entend, par émulateur, un dispositif permettant de simuler, sur la plateforme associée, le fonctionnement logique d'une unité de calcul, d'un processeur du calculateur.

Dans un tel mode de fonctionnement avec un émulateur, le processeur du calculateur est remplacé par une sonde qui assure l'interface avec la plateforme associée portant l'émulation du processeur.

Ainsi, il est possible de faire exécuter le logiciel à tester sur le calculateur, sauf pour la partie processeur et, par des fonctions propres de la plateforme associée, d'observer le fonctionnement ou certains dysfonctionnements internes du logiciel, par exemple, en réponse à des stimulations des entrées des unités d'entrée/sortie, en plus de l'observation des sorties desdites unités d'entrée/sortie.

Cette première méthode présente de nombreux inconvénients. En effet, chaque type de calculateur à tester nécessite un banc de tests spécifique ou pour le moins une configuration très spécialisée d'un banc de test. Un banc de tests est un ensemble comportant, en particulier, des moyens d'interconnexion avec le calculateur à tester, des moyens pour émuler le ou les processeurs du calculateur ainsi que pour exécuter des programmes de tests.

Comme chaque processeur nécessite un émulateur spécifique, tant pour le logiciel d'émulation que pour la sonde se raccordant à la place du processeur, il est nécessaire de multiplier les émulateurs conformément aux définitions des calculateurs.

Par ailleurs, les possibilités d'investigation au moyen des émulateurs sont en général limitées. De plus, la nécessité de travailler avec un langage machine spécifique du processeur considéré implique que l'utilisateur soit un spécialiste de la programmation en langage machine.

En outre, un émulateur est un produit coûteux qui n'est généralement produit qu'en faible quantité. Le cycle de vie de ce type de produit est très court (6 mois à 2 ans) alors que le maintien en condition opérationnelle des moyens de développement et de vérification est exigible (réglementations, réactivité industrielle) pour la durée du programme avion (20 ans, voire plus). Cela se traduit par des problèmes de traitement d'obsolescence de plus en plus difficiles à résoudre.

Cette solution de l'émulateur s'avère donc mal adaptée car, outre ses performances limitées en termes d'investigation, elle est coûteuse à mettre en place et coûteuse à entretenir.

Le coût se trouve également pénalisé par le fait que différents modèles de processeurs sont en général utilisés pour assurer des redondances fonctionnelles, par sécurité de conception, multipliant d'autant les besoins en émulateurs.

Une deuxième méthode, qui vise à s'affranchir des problèmes des émulateurs, consiste à simuler, sur une plateforme hôte, le fonctionnement du calculateur devant exécuter le programme à tester. Dans ce cas, les logiciels sous test doivent accéder à des fichiers de la plateforme hôte, soit pour lire les vecteurs de tests, soit pour enregistrer des résultats de tests.

Comme le logiciel à tester ne comporte pas naturellement les fonctions pour de tels accès aux fichiers de la plateforme hôte, il est nécessaire de modifier le logiciel à tester pour intégrer ces fonctions d'accès.

Pour transférer les informations, on utilise généralement des instructions d'appels système qui sont émises par l'environnement de test simulé. Les instructions d'appels système peuvent être, par exemple, l'ouverture d'un fichier, l'écriture d'un fichier ou encore la lecture d'un fichier. Les instructions d'appels système sont interceptées par le système d'exploitation de la plateforme hôte qui les convertit en appels système de la plateforme hôte.

Cette deuxième méthode présente également des inconvénients. En effet, la variété des fichiers est telle que le développement des fonctionnalités d'accès est très dépendant de la plateforme hôte et de son système d'exploitation. Or, la variabilité des plateformes hôtes est importante tant dans l'espace (cas des équipes de développement dispersées dans le monde) que dans le temps (remplacement des plates-formes hôtes), ce qui pose des difficultés pratiques de mise en oeuvre de la méthode.

Ces difficultés sont accentuées par le fait que des compétences d'experts capables de modifier des fonctions du système d'exploitation sont requises pour le développement de telles fonctionnalités d'accès aux systèmes de fichiers et ne peuvent donc pas être confiées à des spécialistes des essais.

En conséquence, cette méthode s'avère coûteuse et difficile à mettre en oeuvre.

En outre, cette méthode est très intrusive vis-à-vis du logiciel à tester et la modification d'un logiciel, pour en réaliser des tests, est une source de risque de perturbation du fonctionnement du logiciel.

Le document US2003/009305 A1 décrit un procédé de test d'un logiciel sur une plateforme hôte, dans lequel l'utilisateur peut développer des routines de tests sans faire appel aux ressources spécifiques du système d'exploitation de la plateforme hôte, notamment pour l'accès au système de fichier de la plateforme hôte en vue d'enregistrer les résultats du test.

### Exposé de l'invention

La présente invention a pour but de remédier aux inconvénients des techniques exposées précédemment. A cette fin, l'invention propose un procédé qui permet de rajouter des fonctionnalités d'accès à des fichiers de résultats de tests d'une plateforme hôte. Ce rajout de fonctionnalités permet d'enregistrer ou de lire les résultats des tests effectués. Le rajout de fonctionnalités proposé par l'invention est simulé dans une cible virtuelle. Cette cible virtuelle est aussi appelée environnement d'exécution des tests.

L'invention a pour objet un procédé de simulation d'un environnement de test d'un système embarqué réel, sur une plateforme hôte, pour tester un logiciel de fonctionnement.

Plus précisément, l'invention a pour objet un procédé de test d'un logiciel de fonctionnement d'un système embarqué dans un environnement de test virtuel sur une plateforme hôte caractérisé en ce qu'il comporte les étapes suivantes :
- préparation d'un test à effectuer sur le logiciel de fonctionnement en ajoutant et/ou en retirant des fonctions de commande dans une librairie de fonction liée audit logiciel,
- exécution du logiciel de fonctionnement du système embarqué réel dans l'environnement virtuel,
- simulation d'un périphérique dédié par activation de fonction de commande de la librairie, pour observer l'ensemble des résultats de tests du logiciel de fonctionnement et introduire de nouvelles fonctionnalités d'entrées/sorties supplémentaires à celles offertes par le calculateur du système embarqué,
- transmission des résultats de tests du logiciel de fonctionnement à partir du périphérique dédié vers des fichiers de résultats supportés par la plateforme hôte et enregistrement de ces résultats.

L'invention peut comporter également une ou plusieurs des caractéristiques suivantes :
- le périphérique dédié a une adresse virtuelle correspondant à une adresse réelle de l'environnement simulé supporté par la plateforme hôte,
- l'espace d'adressage est un espace mémoire réservé aux entrées-sorties,
- la librairie du système embarqué simulé comporte une bibliothèque de fonctions de commande que le logiciel de fonctionnement active pour contrôler et piloter le périphérique dédié,
- les fonctions de commande de la librairie sont totalement indépendantes de la nature des opérations effectuées par un périphérique ordinaire.

L'invention a également pour objet un dispositif simulant le fonctionnement d'un calculateur de système embarqué à bord d'un aéronef, caractérisé en ce qu'il met en oeuvre le procédé tel que défini précédemment.

Ce dispositif peut comporter une ou plusieurs des caractéristiques suivantes :
- il comporte un environnement de test virtuel sur une plateforme hôte et comprenant un calculateur virtuel, un périphérique ordinaire et un périphérique dédié.
- le calculateur virtuel comporte une unité arithmétique et logique, une mémoire de données, une mémoire programme chargée avec un logiciel de fonctionnement associé à une librairie.

### Brève description des dessins

L'invention sera mieux comprise à la lecture de la description qui suit et à l'examen des figures qui l'accompagnent. Celles-ci sont présentées à titre indicatif et nullement limitatif de l'invention.
La figure 1 est une représentation schématique d'un environnement de test d'un logiciel de fonctionnement d'un système embarqué conformément à l'invention.
La figure 2 illustre un diagramme fonctionnel du procédé de l'invention.

### Description détaillée de modes de réalisation de l'invention

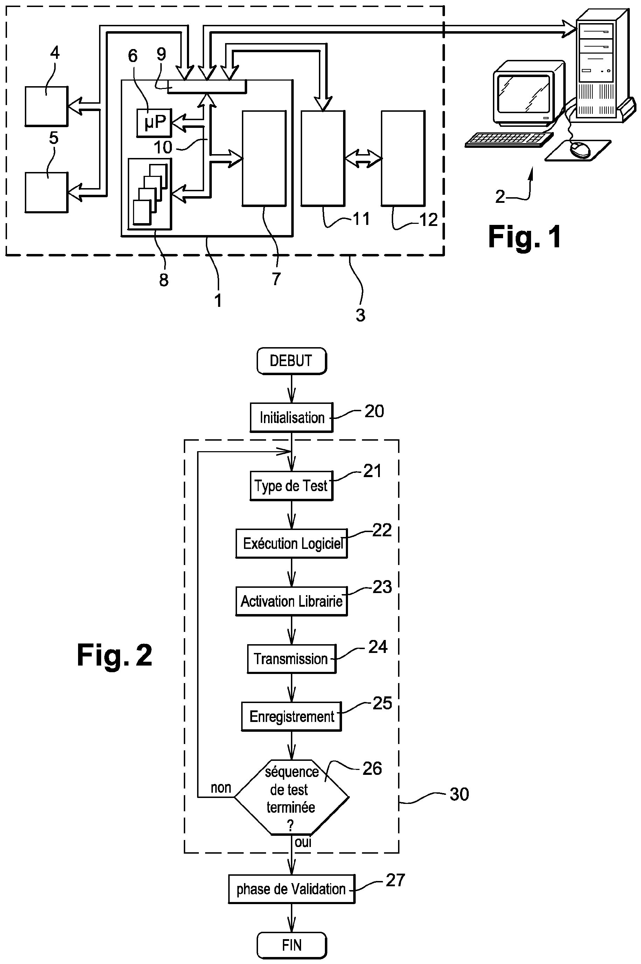

La figure 1 représente un environnement de test permettant de mettre en oeuvre le procédé de test d'un logiciel de fonctionnement d'un système embarqué, selon l'invention.

Le logiciel à tester est destiné à être exécuté dans un calculateur réel, non représenté. Selon l'invention, ce calculateur est simulé. Il porte la référence 1 sur la figure 1.

Ce calculateur simulé 1 est un équivalent virtuel du calculateur réel. Un calculateur réel est destiné à être embarqué, par exemple, dans un aéronef. Le calculateur simulé 1 est implanté dans une cible virtuelle. La cible virtuelle est un environnement où évolue le calculateur simulé 1. Cet environnement, nommé par la suite environnement simulé 3, permet de reproduire, dans une plateforme hôte 2, l'équivalent virtuel des moyens matériels destinés à tester le calculateur réel et, par voie de conséquence, le logiciel de fonctionnement qui y est chargé.

Le calculateur réel est, par exemple, un équipement du système embarqué à bord de l'aéronef et destiné à assurer diverses fonctions nécessaires à l'aéronef, comme des applications de commande de vol, de surveillance de systèmes ou d'affichage d'informations.

L'environnement simulé 3 est un environnement d'exécution des tests du logiciel de fonctionnement.

Le calculateur simulé 1 fonctionne virtuellement dans l'environnement d'exécution des tests. Cet environnement d'exécution des tests est simulé sur la plateforme hôte 2. Le calculateur simulé 1 comporte, de manière non exhaustive, les différents éléments qui se trouvent dans le calculateur réel. Les éléments du calculateur réel sont donc reproduits virtuellement dans le calculateur simulé 1.

La plateforme hôte 2 est, dans le mode de réalisation préféré de l'invention, une station de travail.

Le calculateur simulé 1, centralise les ressources de fonctionnement de l'environnement simulé 3. Sur la figure 1, le calculateur simulé 1 est schématisé par une unité de commande. Cette unité de commande comporte une unité arithmétique et logique 6, une mémoire programme 7, une mémoire de données 8 et une interface d'entrées/sorties 9. L'unité arithmétique et logique 6, la mémoire programme 7, la mémoire de données 8 et l'interface d'entrées/sorties 9 sont connectées les unes aux autres par un bus de communication 10 bidirectionnel.

De manière classique, l'unité arithmétique et logique 6 commandée par des instructions enregistrées dans la mémoire programme 7 exécute les applications du calculateur simulé 1.

La mémoire programme 7 est chargée avec un logiciel de fonctionnement 11. Ce logiciel de fonctionnement 11 comporte des instructions assemblées pour former une chaîne d'instructions. Le logiciel de fonctionnement 11 est destiné à contrôler et à piloter le calculateur réel. Ce même logiciel de fonctionnement est également apte à contrôler et à piloter le calculateur simulé 1 par l'intermédiaire de l'unité arithmétique et logique 6. Le logiciel de fonctionnement reproduit donc les mêmes actions sur le calculateur simulé 1 que sur le calculateur réel.

Le logiciel de fonctionnement 11 comporte également des instructions dont l'exécution permet de simuler un périphérique ordinaire 4. Le périphérique ordinaire 4 simule l'ensemble des fonctionnalités d'entrées/sorties dont dispose le calculateur réel. Autrement dit, le périphérique ordinaire 4 comporte une table d'entrée/sortie identique à celle du périphérique d'entrée/sortie du calculateur réel. Le périphérique ordinaire 4 permet la simulation de valeurs sur la table d'entrée du calculateur réel.

Le calculateur simulé 1 dispose donc d'un périphérique dit ordinaire qui comporte l'équivalent virtuel du périphérique d'entrées/sorties du calculateur réel.

Pour pouvoir observer l'ensemble des résultats de tests et introduire de nouvelles fonctionnalités d'entrée/sortie supplémentaires par rapport à celles offertes par le périphérique ordinaire 4, le logiciel de fonctionnement 11 simule un périphérique dédié 5.

Le périphérique dédié 5 donne accès à des fonctionnalités supplémentaires, non accessibles par le périphérique ordinaire 4. Le périphérique dit dédié comporte notamment des entrées/sorties virtuelles qui sont ajoutées par rapport à celles existantes pour le périphérique d'entrées/sorties du calculateur réel. Ces fonctionnalités supplémentaires peuvent être, notamment, l'accès en lecture et/ou écriture à des fichiers de résultats de tests de la plateforme hôte 2. Ces fonctionnalités supplémentaires sont enregistrées dans une librairie 12. Cette librairie 12 est liée à la fois au logiciel de fonctionnement 11 sous test et au périphérique dédié 5. La librairie 12 comporte une bibliothèque de fonctions de commande, de préférence simples, que le logiciel de fonctionnement peut activer pour commander et piloter le périphérique dédié 5. Cette bibliothèque peut comporter un nombre de modèles de fonctions de commande extensible. Le périphérique dédié 5 permet donc au calculateur simulé 1 d'établir une interface ayant des fonctionnalités supplémentaires par rapport à l'interface avec le périphérique ordinaire 4. Le périphérique dédié permet également d'envoyer des signaux sur les entrées du calculateur simulé 1 ou de lire les sorties dans des fichiers de résultats de tests. L'exécution du logiciel de fonctionnement 11 lui permet de dialoguer avec le calculateur simulé 1 via le périphérique dédié 5 et le périphérique ordinaire 4. Le périphérique dédié 5 est vu comme un périphérique ordinaire 4 par l'unité arithmétique et logique 6.

Les fonctions de commande de la librairie 12 sont totalement indépendantes de la nature des opérations effectuées par le périphérique ordinaire 4.

Du point de vue de l'exécution du logiciel sur le calculateur embarqué (et donc de sa simulation dans l'environnement d'exécution des tests), la fonction de commande est vue comme un ensemble d'adresses mémoire débanalisées.

L'activation ou l'exécution d'une fonction de commande sur le périphérique dédié virtuel se fait généralement suivant les trois étapes suivantes :
- écritures aux adresses des fonctions de commande du périphérique dédié afin de pouvoir transférer les paramètres de la fonction de commande ;
- écriture à une adresse d'une fonction de commande pour lancer l'exécution de ladite fonction ;
- lecture à une adresse de la fonction de commande pour récupérer le statut et éventuellement des données lues.

Le périphérique dédié virtuel est un automate logiciel à trois phases qui fait partie du simulateur. Il est activé sur un accès lecture/écriture à une adresse débanalisée du calculateur virtuel.

Dans une première phase, il stocke les paramètres transmis via les accès mémoire dans une zone tampon unique.

Dans une deuxième phase, l'opération d'entrée/sortie commandée est exécutée, sur la plateforme hôte, avec comme paramètres réels, les paramètres collectés dans la zone tampon.

Dans une troisième phase, le statut est renvoyé via une fonction de commande de lecture.

Dans un exemple, pour une opération d'ouverture de fichier on a « int open(const char *pathname, int flags) », cette fonction a deux paramètres d'entrée « pathname » qui est une adresse et « flags » qui est un entier.

Cette fonction renvoie un identificateur de fichier qui est un entier.

On utilise deux adresses débanalisées pour commander le périphérique dédié virtuel comme « a1, a2 ».

L'exécution, sur le calculateur virtuel, d'une ouverture de fichier, en lecture par exemple donne les instructions suivantes :
const char *fic = "fichier.exemple";
fd = open(fic, O_RDONLY);
fd est la valeur lue.

On obtient donc la séquence suivante sur le calculateur virtuel :
- écrire le-code-de-la-fonction open à l'adresse a1,
- écrire la-valeur-du-pointeur fic à l'adresse a1,
- écrire la-valeur-du-mode-d'ouverture flags à l'adresse a1,
- écrire la-commande-d'execution-de-la-fonction open à l'adresse a2,
- lire la-valeur-du-descripteur-ouvert à l'adresse a1,

On obtient alors la séquence suivante sur lors de l'exécution du périphérique dédié virtuel :
- stocker le-code-de-la fonction dans zone0, remise à zéro de la zone tampon,
- convertir la-valeur-du-pointeur fic en pointeur sur le périphérique dédié virtuel et stocker dans zone1,
- stocker la-valeur-du-mode-d'ouverture dans zone2,
- zoneres = open((const char *)zone1, (int)zone2);
- retourner la valeur-de zoneres en réponse à l'accès en lecture.

Les fonctions de commande « écrire », « lire », « stocker », « retourner » sont des instructions basiques d'affectation.

La fonction de commande « convertir » la-valeur-du-pointeur est une fonction fournie par pratiquement tous les simulateurs de processeurs. Sur un simulateur "basique" où elle n'existerait pas, elle peut être remplacée par une boucle de transfert mot par mot précédée par le transfert de la longueur du bloc de mot.

Ainsi, le logiciel de fonctionnement 11 permet à un utilisateur d'avoir, par l'intermédiaire de la librairie 12, un accès direct en lecture et/ou en écriture à des fichiers de configuration et/ou de résultats de test, au moyen du périphérique dédié 5.

Le calculateur virtuel simulé 1 avec ses périphériques ordinaires 4 et dédiés 5 permettrait de tester le logiciel de fonctionnement durant plusieurs phases de fonctionnement du système embarqué, mais aussi permettrait à l'utilisateur de provoquer volontairement des pannes ou des défaillances matérielles pour déterminer le comportement dudit logiciel.

Le calculateur simulé 1 permet également d'éviter l'utilisation de moyens matériels spécifiques tout en simulant un environnement d'exécution des tests du logiciel de fonctionnement 11. L'utilisation du périphérique dédié permet ainsi d'avoir un environnement d'exécution de tests moins intrusif par rapport à l'art antérieur. Le périphérique dédié 5 est mappé dans l'espace d'adressage de l'unité arithmétique et logique 6 du calculateur simulé 1 virtuel, à des adresses de périphérique non utilisées par l'environnement simulé 3. Autrement dit, l'espace d'adressage (non représenté) de l'unité arithmétique et logique 6, non utilisé par l'environnement simulé, est alloué à des adresses virtuelles du périphérique dédié 5. Cet espace d'adressage peut, selon un mode de réalisation d'architecture de calculateur simulé 1, être dans autrement dit, un espace mémoire réservé aux entrées/sorties, c'est-à-dire dans un espace spécifique d'entrées/sorties.

Le périphérique dédié 5 permet d'accéder à d'autres fonctionnalités disponibles sur la plateforme hôte 2. Pour cela, le périphérique dédié 5 est étendu. Il s'agit du même périphérique que le périphérique dit dédié virtuel 5, à l'exception du fait qu'il est possible d'augmenter le nombre de fonctionnalités autres que des entrées/sorties, de ce dit périphérique, en fonction des possibilités mises à la disposition par la plateforme hôte 2. Ainsi les fonctions supplémentaires peuvent lui être attribuées. Dans ce cas, la librairie 12 est complétée par ajout et/ou par suppression de fonctions de commandes. Ces fonctions sont modifiées par l'utilisateur, c'est-à-dire par le spécialiste des essais du logiciel qui n'est pas, à priori, un spécialiste du système d'exploitation de la plateforme hôte. L'unité arithmétique et logique 6 détermine ensuite, à partir des fonctions de commande présentes dans la librairie, les séquences de test à effectuer sur le logiciel. Autrement dit, le test à effectuer est déterminé à partir des fonctions de commande de la librairie.

On comprend, à la lecture de cette description, que le calculateur simulé 1 ne présente aucun lien direct ou logique avec la plateforme hôte 2.

La figure 2 illustre un diagramme fonctionnel d'une séquence de test suivant le procédé de l'invention. Ce procédé comporte une étape préliminaire 20, dans laquelle le logiciel de fonctionnement est chargé dans la mémoire programme 7 de l'unité de commande du calculateur simulé 1 et les différents paramètres de l'environnement d'exécution des tests dudit logiciel sont réinitialisés. A cette étape, le logiciel de fonctionnement 11 est apte à entrer dans une phase de test 30. La phase de test 30 correspond à un ensemble d'étapes nécessaires pour la vérification du déroulement de l'exécution du logiciel de fonctionnement 11.

Cette phase de test 30 comporte une étape 21 pendant laquelle, l'unité de commande du calculateur simulé 1 détermine le type de test à effectuer sur le logiciel de fonctionnement 11 en ajoutant ou en retirant des fonctions de commande dans la librairie 12.

A l'étape 22, l'unité de commande du calculateur simulé 1 lance l'exécution du logiciel de fonctionnement 11 dans l'environnement simulé 3.

A l'étape 23, l'exécution du logiciel de fonctionnement 11 active et/ou désactive différentes fonctions de la librairie 12 comme les fonctionnalités d'accès à des fichiers de résultats. L'ajout et/ou le retrait de fonctionnalités dans la librairie 12 est possible par l'utilisateur. L'activation de fonctionnalités de la librairie permet de simuler virtuellement le périphérique dédié 5 dans l'environnement simulé 3.

A l'étape 24, l'unité de commande du calculateur simulé 1 transmet, dans des fichiers de la plateforme hôte 2, les fichiers de résultats en fonction du type de test effectué sur le logiciel de fonctionnement 11. En d'autres termes, les résultats des tests sont transmis du périphérique dédié 5 vers des fichiers de la plateforme hôte 2.

A l'étape 25, les fichiers de résultats de tests sont enregistrés sur le système d'exploitation de la plateforme hôte pour être analysés et afin d'assurer la traçabilité des essais en vue de la certification par les autorités compétentes.

A l'étape 26, l'unité de commande détermine si la séquence de test est terminée. Tant que l'unité de commande n'a pas retourné une instruction de fin de test, la phase de test continue, c'est-à-dire que les étapes 21 à 25 sont réitérées.

Lorsque tous les tests nécessaires ont été exécutés avec succès, le logiciel est normalement apte à être intégré dans le calculateur réel. Le procédé se termine, lorsque le logiciel de fonctionnement a été validé avant d'être intégré dans le calculateur réel (étape 27).

L'invention telle qu'elle vient d'être décrite permet une implémentation des fonctionnalités d'accès aux fichiers de résultats simple et flexible, ce qui permet de limiter le coût de développement du logiciel de fonctionnement sous test.

L'invention permet une totale indépendance du périphérique dédié vis-à-vis du système d'exploitation de la plateforme hôte 2, ce qui permet un développement de périphériques dédiés dans l'environnement simulé 3 qui ne demande aucune connaissance particulière, sauf celles qui sont requises pour l'utilisation de fichiers, et rend le dispositif de test pratiquement insensible aux caractéristiques évolutives des plateformes hôtes. L'invention ne nécessite donc aucune notion de distribution de fichiers, ni aucune conversion ou interception d'appel système.

## Revendications

1. Procédé de test d'un logiciel de fonctionnement (11) d'un système embarqué dans un environnement de test virtuel sur une plateforme hôte (2), **caractérisé en ce qu'**il comporte les étapes suivantes :
- préparation d'un test à effectuer sur le logiciel de fonctionnement (11) en ajoutant et/ou en retirant des fonctions de commande dans une librairie (12) de fonction liée audit logiciel,
- exécution du logiciel de fonctionnement destiné au calculateur du système embarqué dans l'environnement virtuel (3),
- simulation du périphérique dédié (5) par activation de fonction de commande de la librairie(12), pour observer l'ensemble des résultats de tests du logiciel de fonctionnement et introduire de nouvelles fonctionnalités d'entrées/sorties supplémentaires à celles offertes par le calculateur du système embarqué,
- transmission des résultats de tests du logiciel de fonctionnement à partir du périphérique dédié (5) vers des fichiers de résultats supportés par la plate-forme hôte (2) et enregistrement de ces résultats.

2. Procédé selon la revendication 1, **caractérisé en ce que** le périphérique dédié (5) a une adresse virtuelle correspondant à une adresse réelle de l'environnement simulé (3) supporté par la plate-forme hôte (2).

3. Procédé selon la revendication 2, **caractérisé en ce que** l'espace d'adressage est un espace mémoire réservé aux entrées-sorties.

4. Procédé selon l'une quelconque des revendications 1 à 3, **caractérisé en ce que** la librairie (12) comporte une bibliothèque de fonctions de commande simples que le logiciel de fonctionnement (11) active pour contrôler et piloter le périphérique dédié (5).

5. Procédé selon la revendication 4, **caractérisé en ce que** les fonctions de commande de la librairie (12) sont totalement indépendantes de la nature des opérations effectuées par le périphérique ordinaire (4).

6. Dispositif simulant le fonctionnement d'un calculateur de système embarqué à bord d'un aéronef, **caractérisé en ce qu'**il met en oeuvre le procédé selon l'une quelconque des revendications 1 à 5.

7. Dispositif selon la revendication 6, **caractérisé en ce qu'**il comporte un environnement de test virtuel (3) sur une plate-forme hôte (2) et comprenant un calculateur virtuel (1), un périphérique ordinaire (4) et un périphérique dédié (5).

8. Dispositif selon la revendication 7, **caractérisé en ce que** le calculateur virtuel (1) comporte une unité arithmétique et logique (6), une mémoire de données (8), une mémoire programme (7) chargée avec un logiciel de fonctionnement (11) associé à une librairie (12).

## Patentansprüche

1. Verfahren zum Test einer Betriebssoftware (11) eines bordeigenen Systems in einer virtuellen Testumgebung auf einer Host-Plattform (2), **dadurch gekennzeichnet, dass** es die folgenden Schritte aufweist:
- Vorbereitung eines an der Betriebssoftware (11) durchzuführenden Tests, indem Steuerfunktionen in einer mit der Software verbundenen Funktions-Programmbibliothek (12) hinzugefügt und/oder entfernt werden,
- Ausführung der für den Rechner des bordeigenen Systems bestimmten Betriebssoftware in der virtuellen Umgebung (3),
- Simulation des dedizierten Peripheriegeräts (5) durch Aktivierung einer Steuerfunktion der Programmbibliothek (12), um die Gesamtheit der Testergebnisse der Betriebssoftware zu beobachten und neue Eingangs-/Ausgangs-Funktionalitäten zusätzlich zu denjenigen einzuführen, die vom Rechner des bordeigenen Systems angeboten werden,
- Übertragung der Testergebnisse der Betriebssoftware ausgehend vom dedizierten Peripheriegerät (5) an Ergebnisdateien, die von der Host-Plattform (2) unterstützt werden, und Speichern dieser Ergebnisse.

2. Verfahren nach Anspruch 1, **dadurch gekennzeichnet, dass** das dedizierte Peripheriegerät (5) eine virtuelle Adresse hat, die einer realen Adresse der von der Host-Plattform (2) unterstützten simulierten Umgebung (3) entspricht.

3. Verfahren nach Anspruch 2, **dadurch gekennzeichnet, dass** der Adressierraum ein Speicherraum ist, der für die Eingänge-Ausgänge reserviert ist.

4. Verfahren nach einem der Ansprüche 1 bis 3, **dadurch gekennzeichnet, dass** die Programmbibliothek (12) eine Bibliothek einfacher Steuerfunktionen aufweist, die die Betriebssoftware (11) aktiviert, um das dedizierte Peripheriegerät (5) zu kontrollieren und zu steuern.

5. Verfahren nach Anspruch 4, **dadurch gekennzeichnet, dass** die Steuerfunktionen der Programmbibliothek (12) von der Beschaffenheit der vom gewöhnlichen Peripheriegerät (4) ausgeführten Vorgänge völlig unabhängig sind.

6. Vorrichtung, die den Betrieb eines Rechners eines an Bord eines Luftfahrzeugs befindlichen Systems simuliert, **dadurch gekennzeichnet, dass** sie das Verfahren nach einem der Ansprüche 1 bis 5 anwendet.

7. Vorrichtung nach Anspruch 6, **dadurch gekennzeichnet, dass** sie eine virtuelle Testumgebung (3) auf einer Host-Plattform (2) aufweist und einen virtuellen Rechner (1), ein gewöhnliches Peripheriegerät (4) und ein dediziertes Peripheriegerät (5) enthält.

8. Vorrichtung nach Anspruch 7, **dadurch gekennzeichnet, dass** der virtuelle Rechner (1) eine arithmetische und logische Einheit (6), einen Datenspeicher (8), einen Programmspeicher (7) aufweist, in den eine einer Programmbibliothek (12) zugeordnete Betriebssoftware (11) geladen ist.

## Claims

1. Method of testing an operating software package (11) of a system embedded in a virtual test environment on a host platform (2), **characterized in that** it comprises the following steps:
- preparation of a test to be performed on the operating software package (11) by adding and/or by removing control functions in a function repository (12) related to the said software package,
- execution of the operating software package intended for the computer of the system embedded in the virtual environment (3),
- simulation of the dedicated peripheral (5) by activation of control function of the repository (12), so as to observe the set of results of tests of the operating software package and to introduce new input/output functionalities additional to those offered by the computer of the embedded system,
- transmission of the results of tests of the operating software package from the dedicated peripheral (5) to results files supported by the host platform (2) and recording of these results.

2. Method according to Claim 1, **characterized in that** the dedicated peripheral (5) has a virtual address corresponding to a real address of the simulated environment (3) supported by the host platform (2).

3. Method according to Claim 2, **characterized in that** the addressing space is a memory space reserved for inputs-outputs.

4. Method according to any one of Claims 1 to 3, **characterized in that** the repository (12) comprises a library of simple control functions that the operating software package (11) activates so as to drive and pilot the dedicated peripheral (5).

5. Method according to Claim 4, **characterized in that** the control functions of the repository (12) are totally independent of the nature of the operations performed by the ordinary peripheral (4).

6. Device simulating the operation of a system computer embedded aboard an aircraft, **characterized in that** it implements the method according to any one of Claims 1 to 5.

7. Device according to Claim 6, **characterized in that** it comprises a virtual test environment (3) on a host platform (2) and comprising a virtual computer (1), an ordinary peripheral (4) and a dedicated peripheral (5).

8. Device according to Claim 7, **characterized in that** the virtual computer (1) comprises an arithmetic and logic unit (6), a data memory (8), a program memory (7) loaded with an operating software package (11) associated with a repository (12).
